# EUROPEAN PATENT SPECIFICATION

(11) **EP 4 262 184 B1**
(45) Date of publication and mention of the grant of the patent: **27.05.2026**
(21) Application number: 21922585.1
(22) Date of filing: 15.12.2021
(51) Int. Cl.: H04N 25/133, G06T 7/30, H04N 25/11, G02B 5/20, H04N 23/15, H04N 23/10, H04N 13/257, G06T 5/50, H04N 23/68, H04N 23/45, H04N 9/73, H04N 25/13

(54) **IMAGE SENSOR, CAMERA, ELECTRONIC DEVICE, AND CONTROL METHOD**
BILDSENSOR, KAMERA, ELEKTRONISCHE VORRICHTUNG UND STEUERUNGSVERFAHREN
CAPTEUR D'IMAGES, CAMÉRA, DISPOSITIF ÉLECTRONIQUE ET PROCÉDÉ DE COMMANDE

(30) Priority: 26.01.2021 CN 202110106228
(43) Date of publication of application: 18.10.2023
(73) Proprietor: Huawei Technologies Co., Ltd., Shenzhen, Guangdong 518129 (CN)
(72) Inventor: SUN, Yuechuan, Shenzhen, Guangdong 518129 (CN); HU, Jia, Shenzhen, Guangdong 518129 (CN); GUO, Yong, Shenzhen, Guangdong 518129 (CN); WANG, Miaofeng, Shenzhen, Guangdong 518129 (CN)
(74) Representative: Körber, Martin Hans
(86) International application number: PCT/CN2021/138512
(87) International publication number: WO 2022/160995

(56) References cited:
- EP-A1- 3 618 430
- CN-A- 104 581 100
- CN-A- 109 979 953
- CN-A- 110 463 197
- CN-A- 110 996 077
- CN-A- 111 131 798
- CN-A- 111 447 380
- US-A1- 2017 257 584
- US-B2- 10 531 067
- TRINIDAD MARC COMINO ET AL: "Multi-View Image Fusion", 2019 IEEE/CVF INTERNATIONAL CONFERENCE ON COMPUTER VISION (ICCV), IEEE, 27 October 2019 (2019-10-27), pages 4100 - 4109, XP033723579, DOI: 10.1109/ICCV.2019.00420
- CHAKRABARTI AYAN; FREEMAN WILLIAM T.; ZICKLER TODD: "Rethinking color cameras", 2014 IEEE INTERNATIONAL CONFERENCE ON COMPUTATIONAL PHOTOGRAPHY (ICCP), IEEE, 2 May 2014 (2014-05-02), pages 1 - 8, XP032605762, DOI: 10.1109/ICCPHOT.2014.6831801

## Description

### TECHNICAL FIELD

This application relates to the field of image processing technologies, and in particular, to an image sensor, a camera, an electronic device, and a control method.

### BACKGROUND

As mobile phone image shooting gradually becomes a preferred way for a user to take a photo, users' needs for mobile phone image shooting are no longer limited to recording of simple image shooting, but an ultimate pursuit of image details and light and shadow art. However, although a color camera currently used in a mobile phone can truly portray an object color in an objective world, because each pixel in the color camera absorbs only light of a specific color in incident light, an image obtained by the color camera in a low light scenario has a low signal-to-noise ratio and poor detail resolution.

US 10,531,067 B2 discloses techniques for generating an image from a multi-camera imaging system that generates color images with high spatial resolution and high color fidelity.

CN 111 131 798 A discloses an image processing method and device for obtaining a target image with clear colors in a low-illumination scene.

CN 104 581 100 A discloses a color filter array and an image processing method for improving the light-sensing performance and resolution degree.

TRINIDAD MARC COMINO ET AL: "Multi-View Image Fusion", 2019 IEEE/CVF INTERNATIONAL CONFERENCE ON COMPUTER VISION (ICCV), IEEE, pages 4100-4109, discloses a system and a method for fusing multiple misaligned photographs of the same scene into a chosen target view.

### SUMMARY

This application provides an image sensor, a camera, and an electronic device, to resolve problems of a low signal-to-noise ratio and poor detail resolution of an image obtained by a color camera in a low light scenario. The invention is defined in the appended claims. In the following, parts of the description and drawings referring to embodiments which are not covered by the claims are not embodiments of the invention, but are examples useful for understanding the invention.

To achieve the foregoing objective, this application uses the following technical solutions.

An aspect of this application provides an image sensor. The image sensor includes a first light filter and a plurality of photoelectric conversion elements. The first light filter includes a plurality of first light filter units arranged in an array. The first light filter unit includes a plurality of light filter blocks arranged in an array. The plurality of light filter blocks include a first transparent light filter block, a second transparent light filter block, and at least two color light filter components. Each color light filter component includes at least three color light filter blocks respectively for transmitting three primary colors of light. The first transparent light filter block and the color light filter blocks are arranged in a staggered manner. The second transparent light filter block is disposed on a periphery of an area in which the first transparent light filter block and the color light filter blocks are located. In addition, each light filter block covers one photoelectric conversion element, and the photoelectric conversion element is configured to convert light passing through the light filter block into an electrical signal. In conclusion, the image sensor provided in this embodiment of this application has the first light filter. The first light filter unit, as a minimum repetition unit of the first light filter, includes a plurality of color light filter blocks used to obtain color information. The foregoing plurality of color light filter blocks may form at least two groups of color light filter components, for example, a first light filter component and a second light filter component. Any one of the first light filter component and the second light filter component may include one blue light filter block, one red light filter block, and two green light filter blocks, so that color information of three primary colors can be obtained. A larger quantity of the foregoing color light filter components indicates more color information obtained by the image sensor. In addition, the first light filter unit further has a plurality of first transparent light filter blocks and a plurality of second transparent light filter blocks for increasing an amount of light entering the image sensor. The first transparent light filter block and the color light filter block are alternately disposed, to increase an amount of light entering an area in which the color light filter block is located. In addition, the second transparent light filter block is disposed on a periphery of an area in which the first transparent light filter block and the color light filter block are located. In this way, a quantity of transparent light filter blocks in the entire first light filter may be increased by setting a quantity of the second transparent light filter blocks, to increase the amount of light entering the image sensor. In this way, compared with a monochrome camera, a first camera having the image sensor can obtain more color information by disposing the color light filter block, so that an image shot by the first camera can have a high color reproduction degree. In addition, compared with a color camera using a Bayer array, the first camera can obtain a high amount of light entering the image sensor by disposing the first transparent light filter block and the second transparent light filter block, to improve detail resolution of an image shot by the first camera in a low light environment, and to reduce a signal-to-noise ratio of the image.

The at least two color light filter components include the first light filter component and the second light filter component. In a same first light filter unit, a plurality of first transparent light filter blocks and a plurality of color light filter blocks are arranged in a 4 × 4 matrix. Any one of the first light filter component and the second light filter component includes one red light filter block, one blue light filter block, and two green light filter blocks. A quantity of green light filter blocks in each light filter component is greater than a quantity of red light filter blocks and a quantity of blue light filter blocks, to meet a characteristic that human eyes are sensitive to green.

Optionally, a red light filter block and a blue light filter block in the first light filter component and a red light filter block and a blue light filter block in the second light filter component are sequentially arranged along a direction of a diagonal of the 4 × 4 matrix. The two green light filter blocks in the first light filter component and the two green light filter blocks in the second light filter component are respectively distributed on both sides of the diagonal of the 4 × 4 matrix. A quantity of green light filter blocks in each light filter component is greater than a quantity of red light filter blocks and a quantity of blue light filter blocks, to meet a characteristic that human eyes are sensitive to green.

Optionally, a blue light filter block in the first light filter component, a blue light filter block in the second light filter component, a red light filter block in the first light filter component, and a red light filter block in the second light filter component are sequentially arranged along a direction of a diagonal of the 4 × 4 matrix. The two green light filter blocks in the first light filter component and the two green light filter blocks in the second light filter component are respectively distributed on both sides of the diagonal of the 4 × 4 matrix. A quantity of green light filter blocks in each light filter component is greater than a quantity of red light filter blocks and a quantity of blue light filter blocks, to meet a characteristic that human eyes are sensitive to green.

Optionally, the two green light filter blocks in the first light filter component and the two green light filter blocks in the second light filter component are sequentially arranged along a direction of a diagonal of the 4 × 4 matrix. A blue light filter block in the first light filter component, a blue light filter block in the second light filter component, a red light filter block in the first light filter component, and a red light filter block in the second light filter component are respectively arranged on both sides of the diagonal of the 4 × 4 matrix. A quantity of green light filter blocks in each light filter component is greater than a quantity of red light filter blocks and a quantity of blue light filter blocks, to meet a characteristic that human eyes are sensitive to green.

Optionally, the plurality of light filter blocks in the first light filter unit are arranged in an S × J matrix, where 4 < S, 4 < J, and S and J are even numbers. When S or J is less than 4, a quantity of transparent light filter blocks in the first light filter unit is small, and this affects an amount of light entering the image sensor, and is unfavorable to improving quality of an image shot in a low light environment. Upper limits of S and J are not limited in this application.

Another aspect of this application provides a camera. The camera includes a lens assembly and any image sensor described above, and the lens assembly is disposed on a light incident side of the image sensor. The camera has a same technical effect as that of the image sensor provided in the foregoing embodiment. Details are not described herein again.

Another aspect of this application provides an electronic device. The electronic device includes a processor and a first camera electrically connected to the processor. The first camera is the foregoing camera. The electronic device has a same technical effect as the camera provided in the foregoing embodiment. Details are not described herein again.

Optionally, the electronic device further includes a second camera electrically connected to the processor. The second camera includes a second light filter. The second light filter includes a plurality of second light filter units arranged in an array, and the second light filter unit includes one red light filter block, one blue light filter block, and two green light filter blocks arranged in a 2 × 2 matrix. The two green light filter blocks are arranged along one diagonal of the 2 × 2 matrix, and the red light filter block and the blue light filter block are arranged along the other diagonal of the 2 × 2 matrix. In this way, when the first camera and the second camera work simultaneously, an image finally displayed by the electronic device can balance rich details of an image shot by the first camera and accurate colors of an image shot by the second camera.

### BRIEF DESCRIPTION OF DRAWINGS

FIG. 1A is a schematic diagram of a structure of an electronic device according to an embodiment of this application;
FIG. 1B is a schematic diagram of a structure of another electronic device according to an embodiment of this application;
FIG. 2A is a schematic diagram of a structure of a first camera in FIG. 1A or FIG. 1B;
FIG. 2B is a schematic diagram of a structure of a first light filter of an image sensor in FIG. 2A;
FIG. 2C is a schematic diagram of a structure of a first light filter unit in FIG. 2B;
FIG. 2D is a schematic diagram of another structure of a first light filter of an image sensor in FIG. 2A;
FIG. 3A is a schematic diagram of a partial structure of a first light filter unit in FIG. 2C;
FIG. 3B is another schematic diagram of a partial structure of a first light filter unit in FIG. 2C;
FIG. 3C is another schematic diagram of a partial structure of a first light filter unit in FIG. 2C;
FIG. 3D is another schematic diagram of a partial structure of a first light filter unit in FIG. 2C;
FIG. 3E is another schematic diagram of a partial structure of a first light filter unit in FIG. 2C;
FIG. 4 is a schematic diagram of a structure of an image sensor in FIG. 2A;
FIG. 5A is a schematic diagram of image shooting according to an embodiment of this application;
FIG. 5B is a schematic diagram of another image shooting according to an embodiment of this application;
FIG. 6 is a schematic diagram of a structure of an electronic device according to an embodiment of this application;
FIG. 7 is a flowchart of an image processing method according to an embodiment of this application;
FIG. 8 is a schematic diagram of interface display of an electronic device according to an embodiment of this application;
FIG. 9A is a schematic diagram of a hand shaking track in an image shooting process of a user according to an embodiment of this application;
FIG. 9B is a schematic diagram of a target image to be shot by a first camera according to an embodiment of this application;
FIG. 10A, FIG. 10B, FIG. 10C, and FIG. 10D are respectively schematic diagrams of a first frame of image, a second frame of image, a third frame of image, and a fourth frame of image that are shot by a first camera according to an embodiment of this application;
FIG. 11A is a schematic diagram of a superposition effect in which a first camera shoots a plurality of frames of images according to an embodiment of this application;
FIG. 11B is a schematic diagram of another superposition effect in which a first camera shoots a plurality of frames of images according to an embodiment of this application;
FIG. 12A is a schematic diagram of a structure of another electronic device according to an embodiment of this application;
FIG. 12B is a schematic diagram of a structure of an image sensor in a second camera in FIG. 12A;
FIG. 13 is another schematic diagram of interface display of an electronic device according to an embodiment of this application;
FIG. 14 is a flowchart of another image processing method according to an embodiment of this application;
FIG. 15A is a schematic diagram of an image shot by a first camera in FIG. 12A;
FIG. 15B is a schematic diagram of an image shot by a second camera in FIG. 12A;
FIG. 15C is a schematic diagram of optical flow values of the image shown in FIG. 15A and the image shown in FIG. 15B;
FIG. 16 is an optical flow confidence map between the image shown in FIG. 15A and the image shown in FIG. 15B; and
FIG. 17 is a flowchart of another image processing method according to an embodiment of this application.

Reference numerals:
01-Electronic device; 10-Shell; 11-First camera; 20a-Image sensor of a first camera; 30-Lens assembly; 301-Lens; 200-First light filter; 210-First light filter unit; 211-Light filter block; 212-Color light filter block; 40a-First light filter component, 40b-Second light filter component, 40-Color light filter component; 41-Photoelectric conversion element; 02-Processor; 03-Camera button; 12-Second camera; 20b-Image sensor of a second camera; and 310-Second light filter unit.

### DESCRIPTION OF EMBODIMENTS

The following describes the technical solutions in embodiments of this application with reference to the accompanying drawings in embodiments of this application. It is clear that the described embodiments are merely a part rather than all of embodiments of this application.

The terms "first" and "second" and the like mentioned below are merely intended for a purpose of description, and shall not be understood as an indication or implication of relative importance or implicit indication of a quantity of indicated technical features. Therefore, a feature limited by "first" or "second" and the like may explicitly or implicitly include one or more features.

In addition, in this application, orientation terms such as "upper", "lower", "left", and "right" may be defined by, but are not limited to, orientations of components schematically placed in the accompanying drawings. It should be understood that these orientation terms may be relative concepts, and are used for description and clarification of "relative", and may change correspondingly according to a change in a placement orientation of a component drawing in the drawings.

In this application, unless otherwise specified and limited, the term "connection" should be understood in a broad sense. For example, the "connection" may be a fixed connection, a detachable connection, an integration, a direct connection, or an indirect connection by using an intermediate medium. In addition, the term "electrical connection" may be a direct electrical connection, or may be an indirect electrical connection through an intermediate medium.

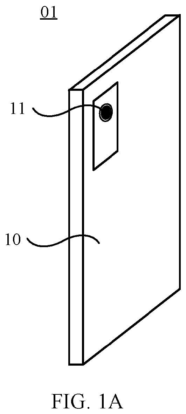

Embodiments of this application provide an electronic device. The electronic device includes an electronic product having a photographing function, for example, a mobile phone (mobile phone), a tablet computer (tablet computer), a television, an intelligent wearable product (for example, a smartwatch or a smart band), a virtual reality (virtual reality, VR) electronic device, or an augmented reality (augmented reality, AR) electronic device. A specific form of the electronic device is not specifically limited in embodiments of this application. For ease of description, an example in which an electronic device 01 is a mobile phone shown in FIG. 1A is used below for description.

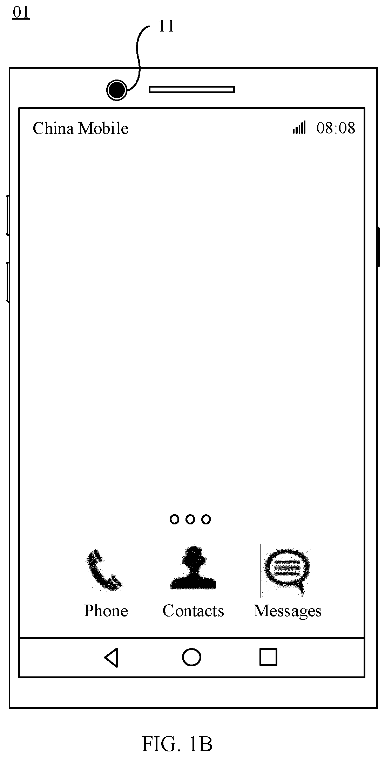

The electronic device 01 may include a first camera 11. In some embodiments of this application, as shown in FIG. 1A, the first camera 11 may be disposed, as a rear-facing camera, on a side in which a shell 10 of the electronic device 01 is located. Alternatively, in some other embodiments of this application, as shown in FIG. 1B, the first camera 11 may be disposed, as a front-facing camera, on a side on which the electronic device 01 displays an image.

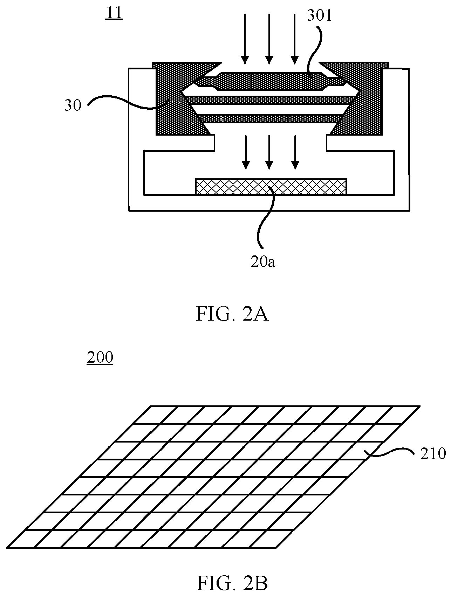

The first camera 11 may include an image sensor 20a shown in FIG. 2A and a lens assembly 30 disposed on a light incident side of the image sensor 20a. The lens assembly 30 may include at least two lenses 301 disposed in a stacked manner. The lens assembly 30 can converge external light (as shown in an arrow in the figure), and then the external light is incident to the image sensor 20a.

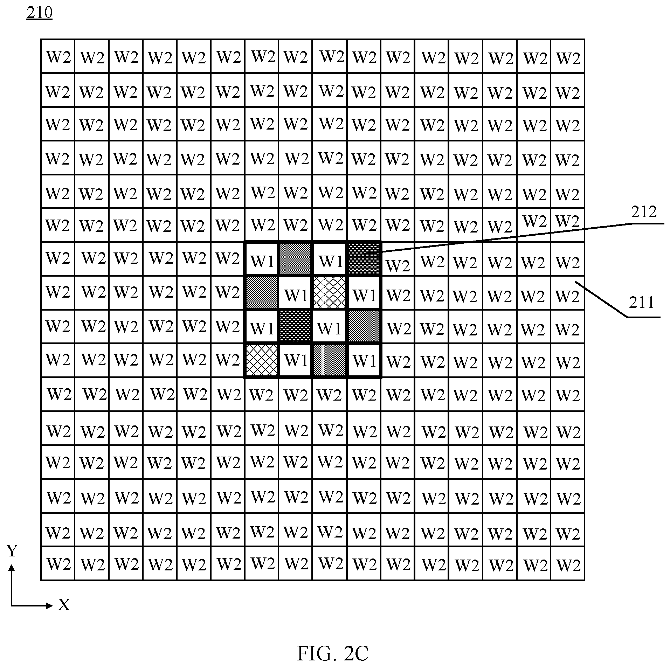

The image sensor 20a of the first camera 11 may include a first light filter (color filter array, CFA) 200 shown in FIG. 2B. The first light filter 200 may include a plurality of first light filter units 210 arranged in an array. The first light filter unit 210 may include a plurality of light filter blocks 211 arranged in an array as shown in FIG. 2C. The plurality of light filter blocks 211 may be arranged in an S × J matrix. FIG. 2C is described by using S = J = 16 as an example.

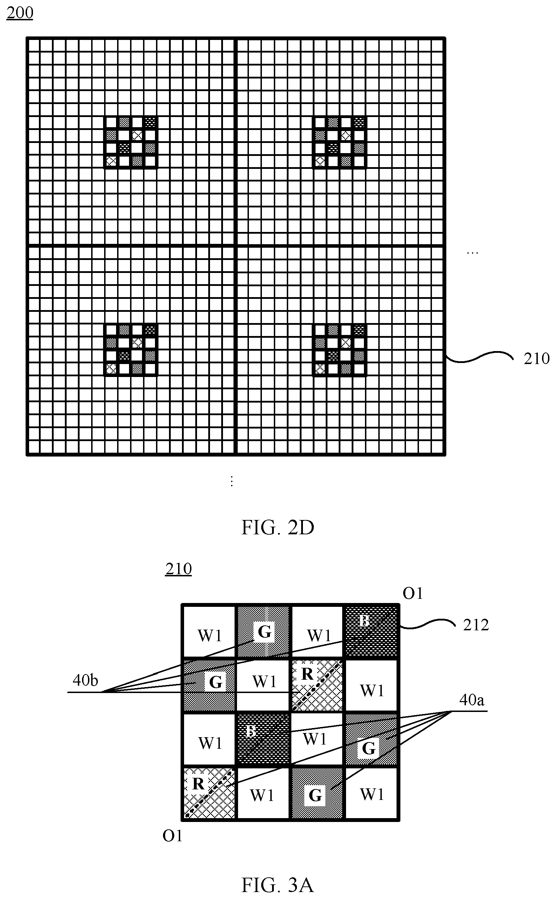

In some embodiments of this application, the plurality of light filter blocks 211 in the first light filter unit 210 may include a first transparent light filter block W1, a second transparent light filter block W2, and a plurality of color light filter blocks 212 shown in FIG. 2C. The color light filter block 212 and the first transparent light filter block W1 are arranged in a staggered manner. The second transparent light filter block W2 is disposed in a periphery of an area in which a plurality of first transparent light filter blocks W1 and a plurality of color light filter blocks 212 are located. The first transparent light filter block W1 and the second transparent light filter block W2 are configured to directly transmit the light passing through the lens 301 in FIG. 2A. As shown in FIG. 2D, the first light filter unit 210 may be used as a minimum repetition unit of the first light filter 200.

It should be noted that, that the color light filter block 212 and the first transparent light filter block W1 are arranged in a staggered manner means that there is one first transparent light filter block W1 between two adjacent color light filter blocks 212 along a horizontal direction X or a vertical direction Y of a matrix formed by the plurality of light filter blocks 211 in the first light filter unit 210.

In some embodiments of this application, materials of the first transparent light filter block W1 and the second transparent light filter block W2 may be the same. In this case, light transmittances of the first transparent light filter block W1 and the second transparent light filter block W2 may be the same. Alternatively, in some other embodiments of this application, materials of the first transparent light filter block W1 and the second transparent light filter block W2 may be different. This is not limited in this application.

In addition, in some embodiments of this application, as shown in FIG. 3A, a first light filter unit 210 may include two color light filter components: a first light filter component 40a and a second light filter component 40b. Any one of the color light filter components of the first light filter component 40a and the second light filter component 40b may include at least three color light filter blocks that are respectively configured to transmit three-primary-color light, for example, red (red, R) light, blue (blue, B) light, and green (green, G) light. Because human eyes are sensitive to green, in a same first light filter unit 210, a quantity of green light filter blocks G may be greater than a quantity of light filter blocks of other colors. For example, when a plurality of first transparent light filter blocks W and a plurality of color light filter blocks are arranged in a 4 × 4 matrix, any one of the foregoing color light filter components may include one blue light filter block B, one red light filter block R, and two green light filter blocks G.

Based on this, the blue light filter block B is configured to transmit blue light in the light from the lens 301 in FIG. 2A, and filter out remaining light. The red light filter block R is configured to transmit red light in the light from the lens 301, and filter out remaining light. The green light filter block G is configured to transmit green light in the light from the lens 301, and filter out remaining light. In this way, the light from the lens 301 can be split into three-primary-color (R, G, B) light after passing through the color light filter component, so that the electronic device 01 can obtain an RGB domain image.

The following describes a manner of setting each color light filter block 212 in the first light filter component 40a and the second light filter component 40b. In some embodiments of this application, as shown in FIG. 3A, along a diagonal (O1-O1) direction of the 4 × 4 matrix, a red light filter block R and a blue light filter block B in the first light filter component 40a and a red light filter block R and a blue light filter block B in the second light filter component 40b are sequentially arranged. In addition, two green light filter blocks G in the first light filter component 40a and two green light filter blocks G in the second light filter component 40b may be respectively distributed on both sides of the diagonal (O1-O1) of the 4 × 4 matrix.

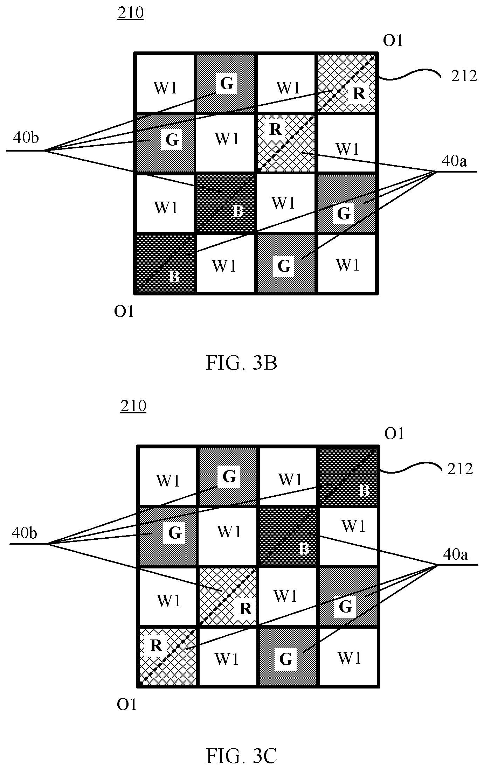

Alternatively, in some other embodiments of this application, as shown in FIG. 3B, along a diagonal (O1-O1) direction of the 4 × 4 matrix, a blue light filter block B in the first light filter component 40a, a blue light filter block B in the second light filter component 40b, a red light filter block R in the first light filter component 40a, and a red light filter block R in the second light filter component 40b are sequentially arranged. Alternatively, as shown in FIG. 3C, along a diagonal (O1-O1) direction of the 4 × 4 matrix, a red light filter block R in the first light filter component 40a, a red light filter block R in the second light filter component 40b, a blue light filter block B in the first light filter component 40a, and a blue light filter block B in the second light filter component 40b are sequentially arranged. In addition, as shown in FIG. 3B or FIG. 3C, two green light filter blocks G in the first light filter component 40a and two green light filter blocks G in the second light filter component 40b may be respectively distributed on both sides of the diagonal (O1-O1) of the 4 × 4 matrix.

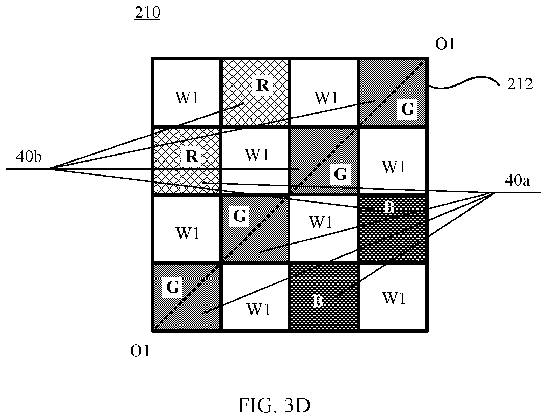

Alternatively, in some other embodiments of this application, as shown in FIG. 3D, along a diagonal (O1-O1) direction of the 4 × 4 matrix, two green light filter blocks G in the first light filter component 40a and two green light filter blocks G in the second light filter component 40b are sequentially arranged. In addition, the blue light filter block B in the first light filter component 40a, the blue light filter block B in the second light filter component 40b, the red light filter block R in the first light filter component 40a, and the red light filter block R in the second light filter component 40b are respectively arranged on both sides of the diagonal (O1-O1) of the 4 × 4 matrix.

FIG. 3D is described by using an example in which a red light filter block R in the first light filter component 40a and a red light filter block R in the second light filter component 40b are located above the diagonal (O1-O1) of the 4 × 4 matrix, and a blue light filter block B in the first light filter component 40a and a blue light filter block B in the second light filter component 40b are located below the diagonal (O1-O1) of the 4 × 4 matrix. In some other embodiments of this application, the red light filter block R in the first light filter component 40a and the red light filter block R in the second light filter component 40b may be located below the diagonal (O1-O1) of the 4 × 4 matrix. The blue light filter block B in the first light filter component 40a and the blue light filter block B in the second light filter component 40b may be located above the diagonal (O1-O1) of the 4 × 4 matrix.

It should be noted that, the foregoing uses a case in which any first light filter unit 210 in a first light filter 200 includes the first light filter component 40a and the second light filter component 40b as an example to describe a manner of setting each color light filter block 212 in the first light filter component 40a and the second light filter component 40b, and does not limit a manner of setting each color light filter block 212 in the first light filter component 40a and the second light filter component 40b. Other manners of setting each color light filter block 212 in the first light filter component 40a and the second light filter component 40b are not described in detail herein.

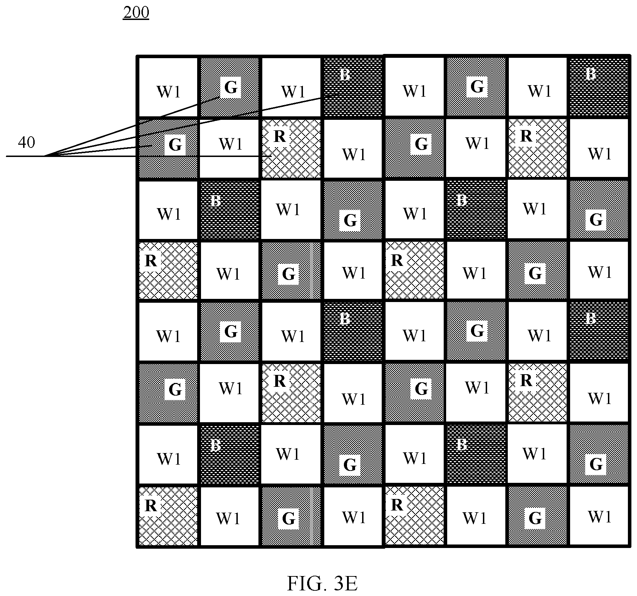

In addition, the foregoing description is provided by using an example in which the first light filter 200 includes two color light filter components, for example, the first light filter component 40a and the second light filter component 40b. In some other embodiments of this application, as shown in FIG. 3E, the first light filter 200 may alternatively include three or more color light filter components 40. For ease of description, the following is described by using an example in which the first light filter 200 includes the first light filter component 40a and the second light filter component 40b, and each color light filter block 212 in the first light filter component 40a and the second light filter component 40b is described in a manner shown in FIG. 3A.

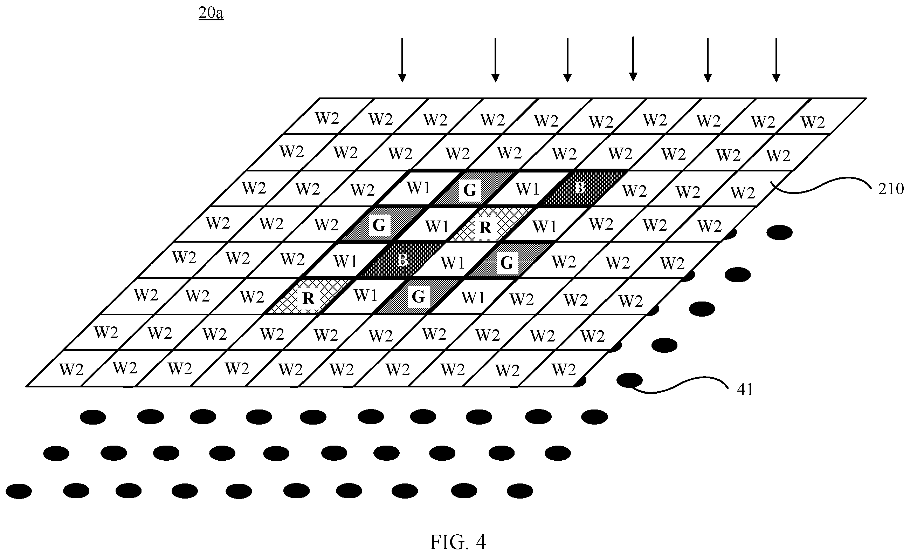

On this basis, as shown in FIG. 4, the image sensor 20a further includes a plurality of photoelectric conversion elements 41. In the first light filter unit 210, a position of each light filter block 211 may correspond to a position of one photoelectric conversion element 41, so that each light filter block 211 may cover one photoelectric conversion element 41. The photoelectric conversion element 41 may be a photodiode, and is configured to convert light passing through the light filter block 211 into an electrical signal.

For example, the photodiode may be manufactured by using a charge-coupled device (charge-coupled device, CCD) technology. The photodiode may convert a collected optical signal (represented in an arrow in FIG. 4) into an electrical signal, and then convert the electrical signal into a digital image signal through amplification and an analog-to-digital conversion circuit. Alternatively, the photodiode may be manufactured by using a complementary metal oxide semiconductor (complementary metal oxide semiconductor, CMOS) technology. The photodiode manufactured by using the CMOS technology has both an N-type semiconductor and a P-type semiconductor. Currents generated by the two semiconductors through a complementary effect may be recorded and interpreted by a processing chip, and converted into a digital image signal by using a digital-to-analog conversion circuit.

It can be known from the foregoing that the image sensor 20a may include the first light filter 200 and the plurality of photoelectric conversion elements 41, and a position of each photoelectric conversion element 41 corresponds to one light filter block 211 in the first light filter 200. In a case in which the light filter block 211 is the first transparent light filter block W1 or the second transparent light filter block W2, all or approximately all light, for example, white (white, W) light, incident to the light filter block 211 may transmit, enter a photoelectric conversion element 41 corresponding to the position of the light filter block 211, and is converted into an electrical signal under an effect of the photoelectric conversion element 41. In addition, when the light filter block 211 is the foregoing color light filter block, for example, the blue light filter block B, the red light filter block R, or the green light filter block G, only light that is incident to the light filter block 211, for example, W light, and whose color is consistent with that of the color light filter block 212, can transmit, enter the photoelectric conversion element 41 corresponding to the position of the light filter block 211, and is converted into an electrical signal under effect of the photoelectric conversion element 41.

In this case, the one light filter block 211 and the photoelectric conversion element 41 corresponding to the position of the light filter block 211 may form a pixel (pixel) of the image sensor 20a. A digital signal obtained by performing analog-to-digital conversion on an electrical signal obtained by each pixel is a Raw (Raw) domain image output by the image sensor 20a. Because the color light filter block 212, for example, the blue light filter block B, allows light of only one color to transmit, for example, light B, in the Raw domain image, data obtained by a pixel of the image sensor 20a formed by the color light filter block 212 of the image sensor 20a, for example, the blue light filter block B and the photoelectric conversion element 41 corresponding to the color light filter block 212, has only one type of color information (single channel), for example, blue information, and the color information and a color of the color light filter block 212, for example, blue, are consistent. Therefore, the Raw domain image is a single-channel image.

In addition, because any transparent light filter block in the first transparent light filter block W1 or the second transparent light filter block W2 may transmit all or approximately all incident light, for example, W light, in the Raw domain image, there is no color information in data obtained by a pixel of the image sensor 20a formed by the first transparent light filter block W1 or the second transparent light filter block W2 of the image sensor 20a and a photoelectric conversion element 41 corresponding to a position of the transparent light filter block.

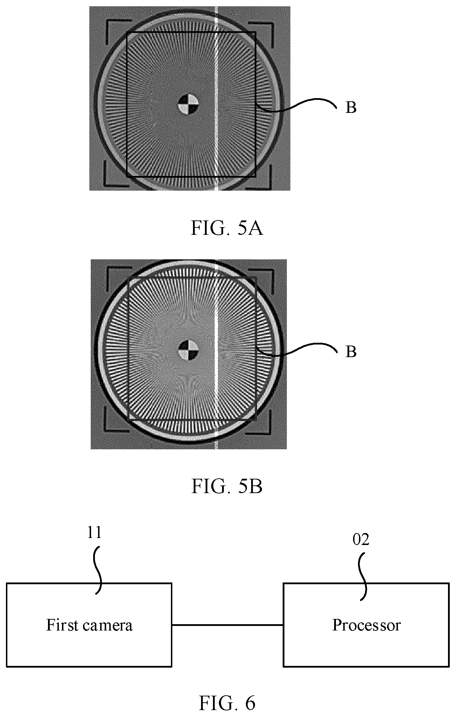

Based on this, because the first transparent light filter block W1 or the second transparent light filter block W2 can transmit all or approximately all incident light, in the image sensor 20a, a larger quantity of the first transparent light filter blocks W1 or the second transparent light filter blocks W2 indicates that the image sensor 20a may obtain a larger amount of incident light by using the transparent light filter blocks, to effectively improve photoelectric conversion efficiency of the image sensor 20a. In this way, when an image is shot in a low light environment, quality of a to-be-shot image can be improved, for example, a signal-to-noise ratio and image detail resolution. For example, when a small amount of light enters the image sensor 20a, an image shot by the image sensor 20a is shown in FIG. 5A, and blurring occurs on a line pattern in an area B. After the amount of light entering the image sensor 20a increases, an image shot by the image sensor 20a is shown in FIG. 5B. Compared with the image in FIG. 5A, a line pattern in the area B is clearer, the signal-to-noise ratio is lower, and the image detail resolution is stronger.

In addition, because the color light filter block 212 can transmit light whose color is consistent with that of the color light filter block 212, a larger quantity of the color light filter blocks 212 indicate more color information that can be obtained by the image processor 20a by using the color light filter block 212, so that more color information in a Raw domain image shot by a first camera 11 having the image sensor 20a is obtained. In this way, in a process of converting a Raw domain image into an RGB domain image, interpolation estimation needs to be performed on the Raw domain image to calculate information about two other colors, such as red information and green information, based on known color information, such as blue information, in pixels of the Raw domain image. Therefore, when a quantity of the color light filter blocks 212 are larger, and when the first camera 11 having the image sensor 20a shoots an object in an objective world, a degree of color reproduction of an object in the objective world in an image shot by the first camera 11 can be improved, and a color cast and a color difference can be reduced.

In conclusion, the image sensor 20a provided in this embodiment of this application has the first light filter 200. The first light filter unit 210, as a minimum repetition unit of the first light filter 200, has a structure as shown in FIG. 2C, and includes a plurality of color light filter blocks 212 used to obtain color information. The plurality of color light filter blocks 212 may form at least two groups of color light filter components shown in FIG. 3A, for example, the first light filter component 40a and the second light filter component 40b. Any one of the first light filter component 40a and the second light filter component 40b may include one blue light filter block B, one red light filter block R, and two green light filter blocks G, so that color information of three primary colors (R, G, B) can be obtained. A larger quantity of the foregoing color light filter components indicates more color information obtained by the image sensor 20a.

In addition, the first light filter unit 210 further has a plurality of first transparent light filter blocks W1 and a plurality of second transparent light filter blocks W2 for increasing an amount of light entering the image sensor 20a. The first transparent light filter block W1 and the color light filter block 212 are alternately disposed, to increase an amount of light entering an area in which the color light filter block 212 is located. In addition, the second transparent light filter block W2 is disposed on a periphery of an area in which the first transparent light filter block W1 and the color light filter block 212 are located. In this way, a quantity of transparent light filter blocks in the entire first light filter 200 may be increased by setting a quantity of the second transparent light filter blocks W2, to increase the amount of light entering the image sensor 20a.

In this way, compared with a monochrome camera, the first camera 11 having the image sensor 20a can obtain more color information by disposing the color light filter block 212, so that an image shot by the first camera 11 can have a high color reproduction degree. In addition, compared with a color camera using a Bayer (Bayer) array, the first camera 11 can obtain a high amount of light entering the image sensor 20a by disposing the first transparent light filter block W1 and the second transparent light filter block W2, to improve detail resolution of an image shot by the first camera 11 in a low light environment, and to reduce a signal-to-noise ratio of the image.

It can be learned from the foregoing description that the first light filter unit 210 of the minimum repetition unit of the first light filter 200 in the image sensor 20a includes S×J light filter blocks 211 arranged in an array. The S×J light filter blocks 211 include a plurality of color light filter blocks and a plurality of transparent light filter blocks. The foregoing is described by using an example in which S = J = 16. In this embodiment of this application, values of S and J may be 4 < S, 4 < J, and S and J are even numbers. When S or J is less than 4, a quantity of transparent light filter blocks in the first light filter unit 210 is small, and this affects an amount of light entering the image sensor 20a, and is unfavorable to improving quality of an image shot in a low light environment. Upper limits of S and J are not limited in this application. In some embodiments of this application, when S or J is greater than 16, there are many transparent light filter blocks in the first light filter unit 210, and color information in an image shot by the image sensor 20a is reduced. Therefore, a value of S or J may be a value less than or equal to 16. For example, the value of S or J may be 6, 8, 10, 12, 14, or 16. Certainly, in some other embodiments of this application, S or J may select a value greater than 16.

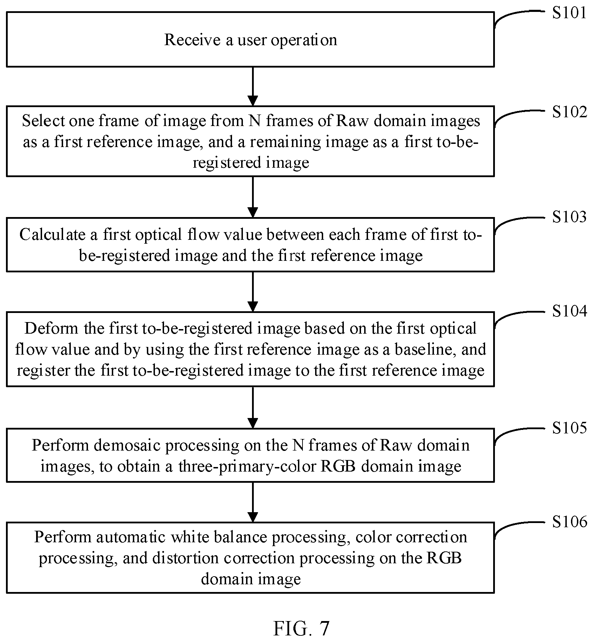

In addition, in a case in which a size of the first light filter unit 210 is fixed, to ensure the amount of light entering the image sensor 20a, a quantity of color light filter blocks cannot be set to be too large. For example, as shown in FIG. 2C, when the first light filter unit 210 includes S×J = 16*16 (256 in total) light filter blocks 211, two blue light filter blocks B, two red light filter blocks R, four green light filter blocks G, in a total of eight color light filter blocks 212 exist in an area in which 4 × 4 light filter blocks 211 in a middle position of the first light filter unit 210 are located. In this case, a proportion of the color light filter blocks 212 in the first light filter unit 210 is 3.125% (8/256 = 3.125%). Based on this, when the electronic device 01 includes a processor 02 that is electrically connected to the first camera 11 and that is shown in FIG. 6, in a process of performing shooting by using the first camera 11, the processor 02 may perform steps S101 to S106 shown in FIG. 7, to improve a degree of color reproduction of an image shot by the first camera 11 when a quantity of color light filter blocks 212 in the first light filter unit 210 is limited.

S101: Receive a user operation.

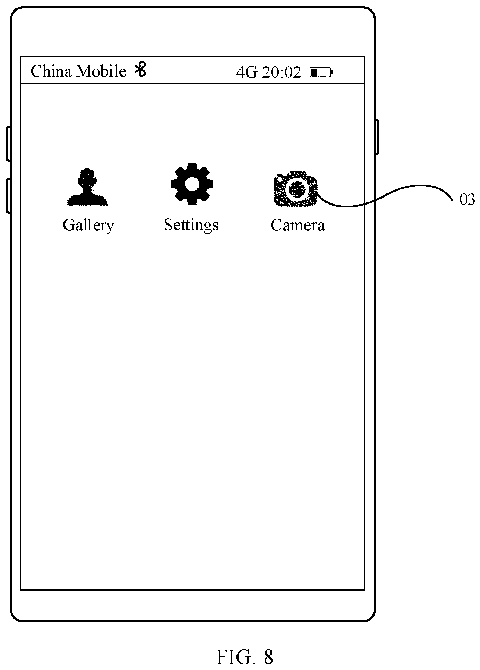

In some embodiments of this application, an example in which the electronic device 01 is a mobile phone shown in FIG. 8 is used. The user operation may be that a user triggers a camera button 03 in the electronic device 01. After receiving the user operation, the processor 02 may send a control instruction to the first camera 11, to trigger the first camera 11 to capture N frames of Raw domain images, where N ≥ 2, and N is an integer. For ease of description, N = 4 is used as an example below. Because a first light filter unit 210 in the first camera 11 includes a red light filter block R, a green light filter block G, a blue light filter block B, and a transparent light filter block (including a first transparent light filter block W1 and a second transparent light filter block W2), a Raw domain image shot by the first camera 11 may be referred to as an RGBW Raw domain image.

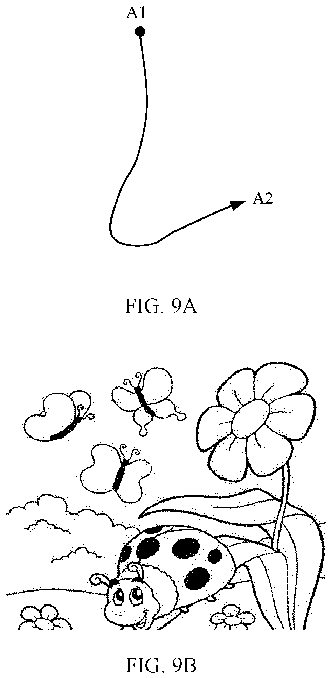

In a case in which the user performs shooting by holding the mobile phone, and in a process in which a finger of the user touches the camera button 03, a hand usually shakes. For example, a hand shaking track may be shown in FIG. 9A, from a location A1 to a location A2. In this case, there is a slight offset between locations of N (for example, N = 4) frames of images that are continuously exposed by the first camera 11.

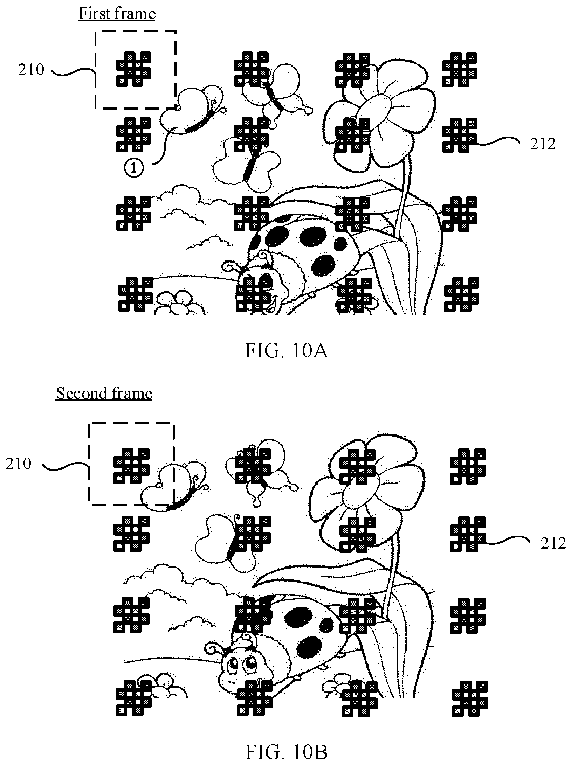

FIG. 9B shows a target image to be shot by the first camera 11. FIG. 10A shows a first frame of image shot by the first camera 11. For ease of description, only a part of a color light filter block 212 in the first light filter unit 210 is represented in four frames of images continuously shot by the first camera 11, and transparent light filter blocks (for example, a first transparent light filter block W1 and a second transparent light filter block W2) in the first light filter unit 210 are not represented. It can be learned from the foregoing description that, because a quantity of color light filter blocks 212 in each first light filter unit 210 is limited, it can be seen from FIG. 10A that, in some areas in the first frame of image, for example, a butterfly No. 1, a body part of a ladybug, and a middle part and a right half part of a flower, because there is no color light filter block 212, colors of the foregoing areas are not captured in the first frame of image.

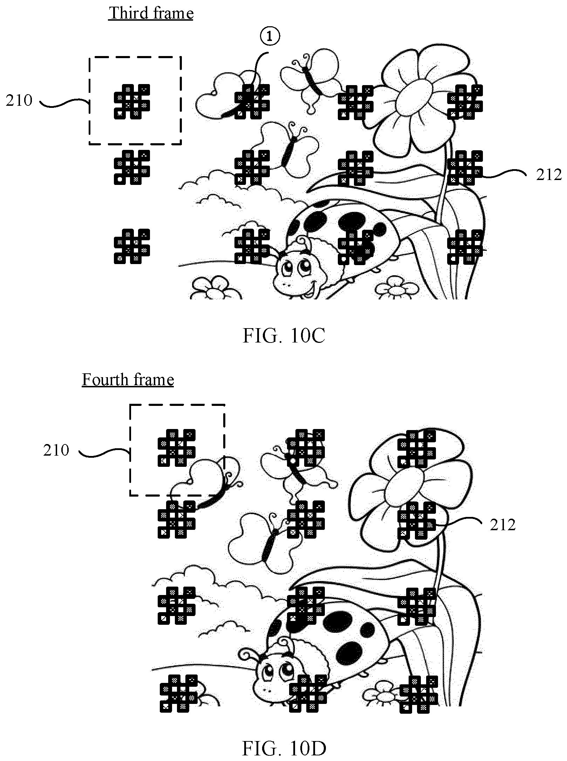

As shown in FIG. 10B, FIG. 10B shows a second frame of image shot by the first camera 11. It can be learned from a moving track of a hand shake of the user shown in FIG. 9A that the first camera 11 shifts towards a lower right corner. Therefore, it can be seen from FIG. 10B that the second frame of image may capture colors of the middle part of the flower, a left half of the ladybug body, and the like. As shown in FIG. 10C, FIG. 10C shows a third frame of image shot by the first camera 11. It can be learned from a moving track of a hand shake of the user shown in FIG. 9A that the first camera 11 shifts towards a lower left corner. Therefore, it can be seen from FIG. 10C that the third frame of image may capture colors of an area such as the right half part of the flower, a right half part of the ladybug body, and a body part of the butterfly No. 1. In addition, as shown in FIG. 10D, FIG. 10D shows a fourth frame of image shot by the first camera 11. It can be learned from a moving track of a hand shake of the user shown in FIG. 9A that the first camera 11 shifts towards an upper right corner. Therefore, as can be seen from FIG. 10D, the fourth frame of image can capture colors of an area such as an upper half part of the flower, an upper half part of the ladybug body, and wings of the butterfly No. 1.

S102: Select one frame of image from the N frames of Raw domain images as a first reference image, and a remaining image as a first to-be-registered image.

It can be learned from the foregoing description that, when the user performs shooting, due to a hand shake, there is a specific location deviation between the N frames of images that are shot. Therefore, the N frames of Raw domain images need to be aligned. In addition, when the user triggers the camera button 03 in the mobile phone, an image seen on a screen of the mobile phone, that is, the first frame of image shot by the first camera 11, is an image that the user expects to finally present. In some embodiments of this application, a first frame of Raw domain image may be selected from the N frames of Raw domain images as the first reference image, and a remaining N-1 frame is a first to-be-registered image. Therefore, the following steps are performed to align the N-1 frame of first to-be-registered image with the first reference image. Certainly, in some other embodiments of this application, any one of the N frames of Raw domain images may be selected as the first reference image, and the remaining N-1 frame is the first to-be-registered image. This is not limited in this application.

S103: Calculate a first optical flow value between each frame of first to-be-registered image and the first reference image.

An optical flow value is used to represent an offset between a reference image and a to-be-registered image. In this case, the first frame of Raw domain image used as the first reference image may be used as a baseline, and first optical flow values between the first frame of Raw domain image and a second frame of Raw domain image to a fourth frame of Raw domain image are calculated one by one by using an optical flow algorithm, for example, Lucas-Kanade.

S104: Deform the first to-be-registered image based on the first optical flow value and by using the first reference image as a baseline, and register the first to-be-registered image to the first reference image.

In a process of performing S104, the second frame of Raw domain image to the fourth frame of Raw domain image may be separately deformed based on the first optical flow values between the first frame of Raw domain image and the second frame of Raw domain image to the fourth frame of Raw domain image, so that content of the second frame of Raw domain image to the fourth frame of Raw domain image is basically the same, and objectives of registration and alignment are achieved. Offsets between transformed second frame of Raw domain image to transformed fourth frame of Raw domain image and the first frame of Raw domain image may be equal to or approximately zero. In this way, texture distortion and ghosting that occur in an image shot due to a hand shake of the user in a shooting process can be reduced.

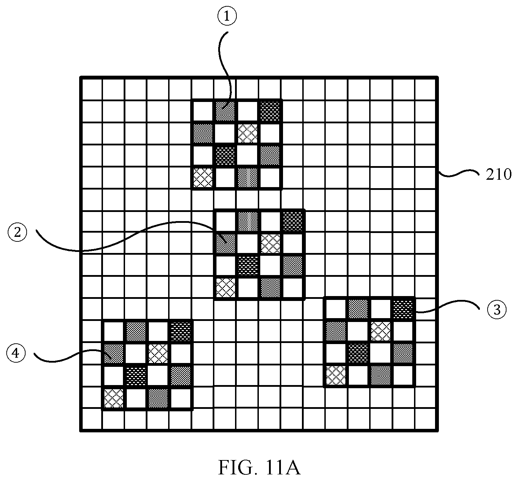

In addition, as shown in FIG. 11A, a location at which a color light filter block 212 in a first frame of Raw domain image 1 captures a color, a location at which a color light filter block 212 in a second frame of Raw domain image 2 captures a color, a location at which a third frame of Raw domain image 3 captures a color, and a location at which a color light filter block 212 in a second frame of Raw domain image 4 captures a color complement each other, so that a quantity of color light filter blocks 212 in an area in which the first light filter unit 210 is located increases.

For example, when the first light filter unit 210 includes 16 × 16 (256 in total) light filter blocks 211, each first light filter unit 210 has eight color light filter blocks 212, and when the first camera 11 continuously exposes four frames of Raw domain images, and after the four frames of Raw domain images are registered, a proportion of the color light filter blocks 212 in the area in which the first light filter unit 210 is located may increase from 3.125% (8/256 = 3.125%) in a single frame to N × 3.125% = 4 × 3.125%. It can be learned that a larger quantity of N indicates a larger proportion of the color light filter blocks 212 in the area in which the first light filter unit 210 is located after the N frames of Raw domain images are superimposed, and indicates more color information obtained by an image sensor 20a. However, when the quantity of N is excessively large, in the following process of performing S105, algorithm complexity is increased, and a calculation amount and a calculation deviation increase sharply. Therefore, a value of N may be set within a range of 2 ≤ N ≤ 8. For example, the value of N may be 2, 3, 4, 5, 6, 7, or 8.

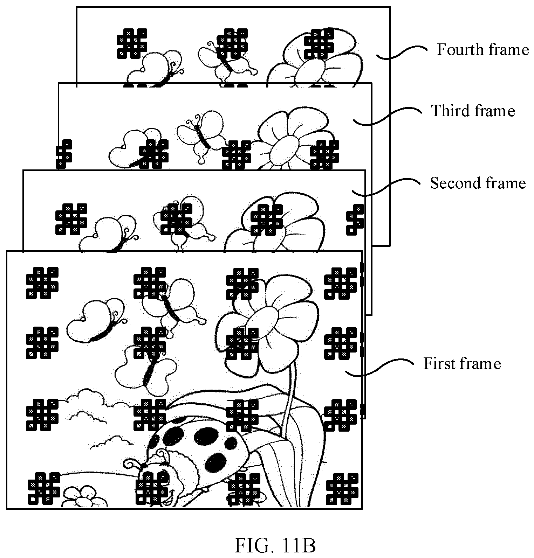

In this case, the image processor 20a in the first camera 11 may obtain more color information by using the color light filter block 212. For example, as shown in FIG. 11B, after the foregoing four frames of Raw domain images are registered, colors of an area such as the middle part of the flower in the first frame of Raw domain image may be compensated by using the second frame of Raw domain image. In addition, colors of an area such as the right half part of the flower in the first frame of Raw domain image may be compensated by using the third frame of Raw domain image. In addition, colors of an area such as the upper half part of the flower in the first frame of Raw domain image may be compensated by using the fourth frame of Raw domain image. In the first frame of Raw domain image, color compensation for other areas, such as the ladybug and the butterfly, may be obtained similarly. Details are not described herein.

S105: Perform demosaic processing on the N frames of Raw domain images to obtain a three-primary-color RGB domain image.

After the foregoing four frames of Raw domain images are registered, a demosaic (Demosaic) module in the processor 02 may perform demosaic processing on registered four frames of single-channel Raw domain images (sizes H × W × 4). In (sizes H × W × 4), "4" indicates four frames. For example, interpolation estimation may be performed on a Raw domain image based on a neural network model in the processor 02, to calculate color information of the other two channels, for example, red information and green information based on known single-channel color information, for example, blue information in a pixel of the Raw domain image. Therefore, a three-channel RGB domain image (size: H × W × 3) can be obtained. In (size: H × W × 3), "3" indicates three channels. H ≥ 1, W ≥ 1, and H and W are positive integers.

It can be learned from the foregoing that colors obtained by the four frames of single-channel Raw domain images may be complementary. Therefore, compared with a manner in which demosaic processing or an RGB domain image is performed only on a single frame of image, the solution of this application can obtain more color details, and a reconstructed RGB domain image is closer to the target image shown in FIG. 9B, so that a degree of color reproduction of an object in the objective world of an image shot by the first camera 11 can be improved, and a color cast and a color difference can be reduced. In addition, because the first light filter unit 210 in the image processor 20a has a large quantity of transparent light filter blocks (including the first transparent light filter block W1 and the second transparent light filter block W2), a large amount of incident light can be obtained when each frame of single-channel Raw domain image is shot, so that the reconstructed RGB domain image can have good detail representation while having color information.

S106: Perform automatic white balance processing, color correction processing, and distortion correction processing and the like on the RGB domain image.

Specifically, an image signal processing (image signal processing, ISP) module in the processor 02 may perform S106, and transmit a processed image to a display of the electronic device 01 for display, so that the user sees an image that is finally shot.

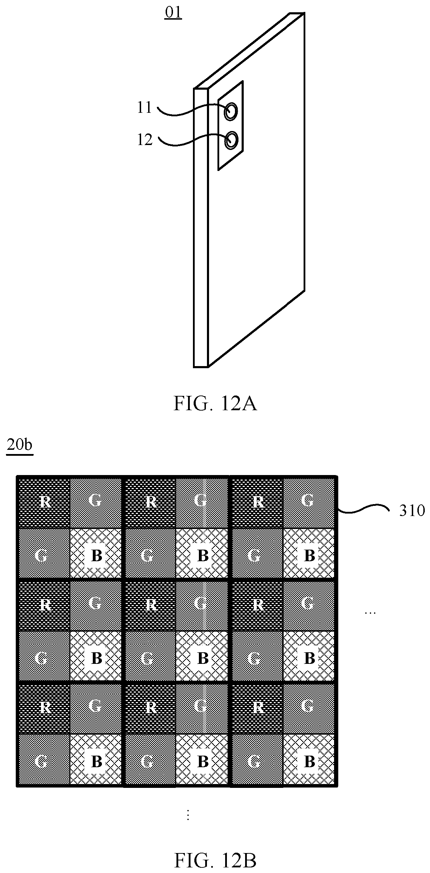

The foregoing description is provided by using an example in which the electronic device 01 has only the first camera 11. In some other embodiments of this application, as shown in FIG. 12A, the electronic device may include the first camera 11 and a second camera 12. Both the first camera 11 and the second camera 12 may be rear-facing cameras, and both are electrically connected to the processor 02. The second camera 12 may also include a lens assembly and an image sensor. A structure of the lens assembly is the same as that described above, and details are not described herein again. For ease of description, in this application, the image sensor of the second camera 12 is represented with "20b", and the image sensor of the first camera 11 is represented with "20a".

As shown in FIG. 12B, the image sensor 20b of the second camera may include a second light filter. The second light filter includes a plurality of second light filter units 310 arranged in an array. The second light filter unit 310 includes one red light filter block R, one blue light filter block B, and two green light filter blocks G that are arranged in a 2 × 2 matrix. The two green light filter blocks G are arranged along one diagonal of the 2 × 2 matrix, and the red light filter block R and the blue light filter block B are arranged along the other diagonal of the 2 × 2 matrix. In this case, the second light filter in the image sensor 20b of the second camera 12 may be a Bayer CFA arranged in RGGB.

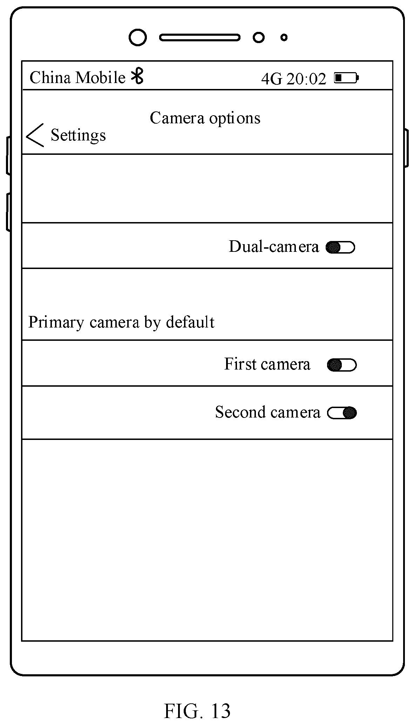

In a shooting process, as shown in FIG. 13, a user may set a first camera 11 or a second camera 12 as a primary camera on an operation interface of an electronic device 01. In addition, the first camera 11 or the second camera 12 may be alternatively set to be turned on or turned off. The primary camera means that content framed by the camera in a shooting process is content that is seen by the user in a viewfinder frame on the display of the electronic device 01. When the user turns off the second camera 12 and uses the first camera 11 to perform shooting, a processor 02 electrically connected to the first camera 11 may perform steps S101 to S106. Details are not described herein again. The following describes in detail an image processing process of the processor 02 when both the first camera 11 and the second camera 12 are in a turn-on state by using an example.

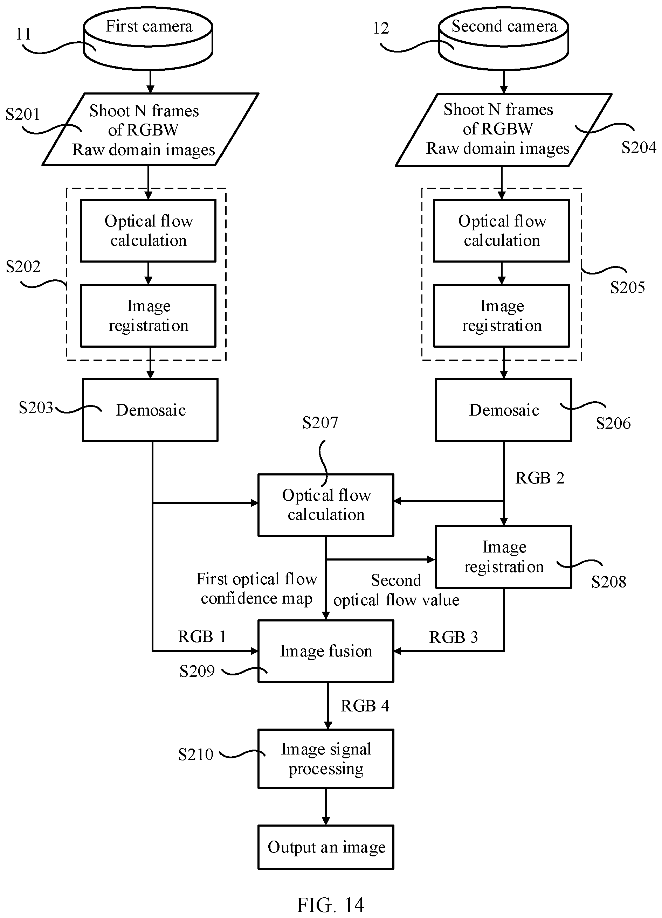

For example, in some embodiments of this application, the user selects a dual-camera mode by using an interface, to simultaneously turn on the first camera 11 and the second camera 12, and uses the first camera 11 as the primary camera. In this case, the processor 02 electrically connected to the first camera 11 and the second camera 12 may receive a user operation. For example, the user operation may be that the user triggers the camera button 03 in the electronic device 01 shown in FIG. 8. After receiving the user operation, the processor 02 may send a control instruction to a first camera 11 and a second camera 12 shown in FIG. 14. The following image processing method may include S201 to S210 shown in FIG. 14.

S201: Shoot N frames of RGBW Raw domain images.

After the first camera 11 receives the control instruction sent by the processor 02, the first camera 11 may shoot the N frames of RGBW Raw domain images, where N ≥ 1. In some embodiments of this application, when N > 1, the processor 02 may perform the following S201 to register the N frames of RGBW Raw domain images. Alternatively, in some other embodiments of this application, when N = 1, the processor 02 may skip S202 and directly perform S203.

S202: Optical flow calculation and image registration.

Specifically, in a process of performing S202, the processor 02 may select, from N frames of first Raw domain images shot by the first camera 11, one frame of image as a third reference image (for example, a first frame of image), and a remaining image as a third to-be-registered image. Next, calculate a third optical flow value between each frame of third to-be-registered image and the third reference image by using the optical flow algorithm. Then, deform the third to-be-registered image based on the third optical flow value and by using the third reference image as a baseline, and register the third to-be-registered image to the third reference image. In this way, registration of N frames of RGBW first Raw domain images is completed.

S203: Demosaic.

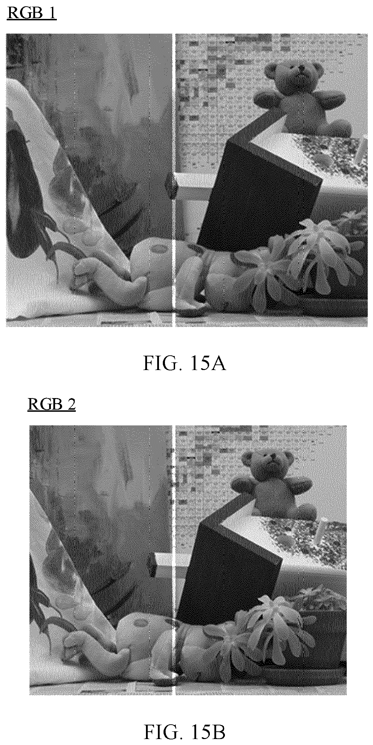

For example, when N = 1, the processor 02 may perform demosaic processing on a single RGBW Raw domain image shot by the first camera 11, to generate a first RGB domain image RGB 1 of three channels. The RGB 1 image may be shown in FIG. 15A. Alternatively, when N > 1, the processor 02 may perform demosaic processing on registered and aligned N frames of RGBW first Raw domain images to generate the foregoing first RGB domain image RGB 1 image.

S204: Shoot M frames of RGBW Raw domain images.

After receiving the control instruction sent by the processor 02, the second camera 12 may shoot the M frames of RGBW Raw domain images, where M ≥ 1. In some embodiments of this application, when M > 1, the processor 02 may perform the following S206 to register the N frames of RGBW Raw domain images. Alternatively, in some other embodiments of this application, when M = 1, the processor 02 may skip S205 and directly perform S206.

S205: Optical flow calculation and image registration.

Specifically, in a process of performing S205, the processor 02 may select, from M frames of second Raw domain images shot by the second camera 12, one frame of image as a fourth reference image (for example, a first frame of image), and a remaining image as a fourth to-be-registered image. Next, calculate a fourth optical flow value between each frame of fourth to-be-registered image and the fourth reference image by using the optical flow algorithm. Then, deform the fourth to-be-registered image based on the fourth optical flow value and by using the fourth reference image as a baseline, and register the fourth to-be-registered image to the fourth reference image. In this way, registration of M frames of RGBW second Raw domain images is completed.

S206: Demosaic.

For example, when M = 1, the processor 02 may perform demosaic processing on a single RGBW Raw domain image shot by the second camera 12, to generate a second RGB domain image RGB 2 of three channels. The RGB 2 image may be shown in FIG. 15B. Alternatively, when M > 1, the processor 02 may perform demosaic processing on registered and aligned M frames of RGBW Raw domain images to generate the second RGB domain image RGB 2.

Because there is a parallax between the first camera 11 and the second camera 12, there is a specific blocking relationship between the two cameras in a shooting process. Therefore, a location of content in the first RGB domain image RGB 1 obtained by the first camera 11 shown in FIG. 15A deviates from a location of content in the second RGB domain image RGB 2 obtained by the second camera 12. For example, a location of a canvas at a left end of the first RGB domain image RGB 1 deviates from a location of a canvas at a left end of the second RGB domain image RGB 2. In addition, a location of a bear at a right end of the first RGB domain image RGB 1 deviates from a location of a bear at a right end of the second RGB domain image RGB 2. Therefore, the following steps need to be performed to align the RGB 1 with the RGB 2.

S207: Optical flow calculation.

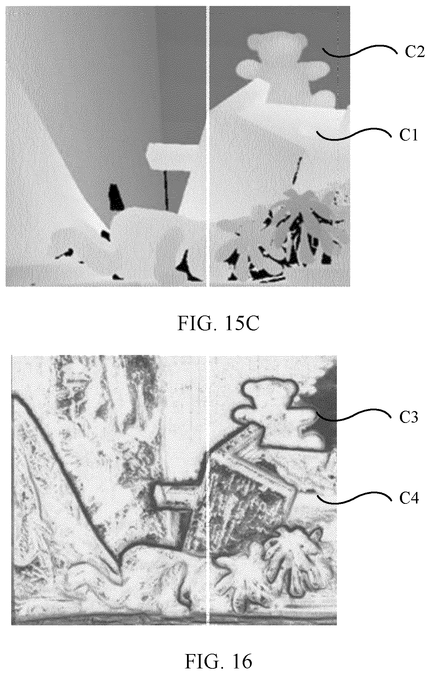

Specifically, in a process of performing S207, the processor 02 may calculate a second optical flow value between the first RGB domain image RGB 1 and the second RGB domain image RGB 2 by using the foregoing optical flow algorithm. The second optical flow value may represent an offset between the RGB 1 and the RGB 2. For example, the second optical flow value may be represented in a manner in FIG. 15C. In FIG. 15C, an optical flow value at a location with a deeper color is larger, and a location offset is larger. On the contrary, an optical flow value at a location with a lighter color is smaller, and a location offset is smaller. For example, in a picture shown in FIG. 15C, an offset between the RGB 1 and the RGB 2 is smaller at a location C1 with a lighter color. On the contrary, an offset between the RGB 1 and the RGB 2 is larger at a location C2 with a deeper color in the picture.

In addition, in a process of performing S207, the processor 02 may further obtain a first optical flow confidence map shown in FIG. 16. In FIG. 16, optical flow confidence at a location C3 with a deeper color is less than optical flow confidence at a location C4 with a lighter color. Higher optical flow confidence indicates that an image shot in the part is more real. A location difference between the RGB 1 and the RGB 2 is mainly caused by a parallax between the first camera 11 and the second camera 12. As a result, an area that cannot be captured exists on an edge part of an object shot because the edge part is blocked. Content of this part is lost. Therefore, it can be seen from FIG. 16 that areas with small optical flow confidence are mainly distributed at edges of the object shot.

S208: Image registration.

Specifically, the processor 02 may select, from the first RGB domain image RGB 1 and the second RGB domain image RGB 2, one image as a second reference image, and the other image as a second to-be-registered image. Next, deform the second to-be-registered image based on the second optical flow value obtained in S207 and by using the second reference image as a baseline, and register the second to-be-registered image to the second reference image, so that content of the first RGB domain image RGB 1 is basically the same as that of the second RGB domain image RGB 2, and the offset between the first RGB domain image RGB 1 and the second RGB domain image RGB 2 may be equal to or approximately zero. After the first RGB domain image RGB 1 is registered with the second RGB domain image RGB 2, a third RGB domain image RGB 3 may be obtained.

It can be learned from the foregoing that, in an image processor 20a of the first camera 11, a first light filter unit 210 includes a color light filter block and a transparent light filter block. Therefore, the RGB 1 image obtained by the first camera 11 has better detail resolution and a better night scene performance capability. However, a quantity of color light filter blocks in the first light filter unit 210 is limited. Therefore, a color loss phenomenon may exist in a small object and a color-rich area. In addition, in an image processor 20b of the second camera 12, a second light filter unit 310 has only a color light filter block. Therefore, the RGB 2 image obtained by the second camera 12 has more real and richer colors. However, because no transparent light filter block is disposed, detail expressiveness and a signal-to-noise ratio of the RGB 2 image are lower. In this way, when the first RGB domain image RGB 1 and the second RGB domain image RGB 2 are registered and aligned to form the third RGB domain image RGB 3, the third RGB domain image RGB 3 may have the detail resolution and the night scene performance capability of the first RGB domain image RGB 1, and may also have advantages of color richness and authenticity of the second RGB domain image RGB 2.

In some embodiments of this application, because the first camera 11 is the primary camera, the first RGB domain image RGB 1 obtained by the first camera 11 may be used as the second reference image, and the second RGB domain image RGB 2 obtained by the second camera 12 may be used as the second to-be-registered image. In this way, the finally registered image is the same as an image that the user expects to shoot by using the primary camera. Certainly, in some other embodiments of this application, the second RGB domain image RGB 2 may be used as the second reference image, and the first RGB domain image RGB 1 may be used as the second to-be-registered image.

S209: Image fusion.

Specifically, the processor 02 may fuse, based on the second optical flow value obtained in S207 by using a fusion algorithm such as a Poisson fusion algorithm, the first RGB domain image RGB 1 that is used as the second reference image, the third RGB domain image RGB 3, and the first optical flow confidence map, to obtain a fourth RGB domain image RGB 4.

In this way, the first RGB domain image RGB 1, the third RGB domain image RGB 3, and the first optical flow confidence map are fused, so that not only information loss and fusion ghosting caused by a parallax in a dual-camera shooting process can be resolved, but also the first optical flow confidence map obtained through optical flow calculation can be used to constrain and guide an information loss area, to focus on color and texture repair of the information loss area by using the first RGB domain image RGB 1 as a baseline. In addition, the obtained fourth RGB domain image RGB 4 can have both rich details of the first RGB domain image RGB 1 and a precise color of the second RGB domain image RGB 2, and can effectively restore texture and a color of a real object at an edge location.

S210: Image signal processing.

Specifically, the ISP module in the processor 02 may perform S210, to perform processing such as automatic white balance processing, color correction processing, and distortion correction processing on the fourth RGB domain image RGB 4. Then, the processed image may be transmitted to a display of the electronic device 01 for display, so that the user sees the image finally shot.

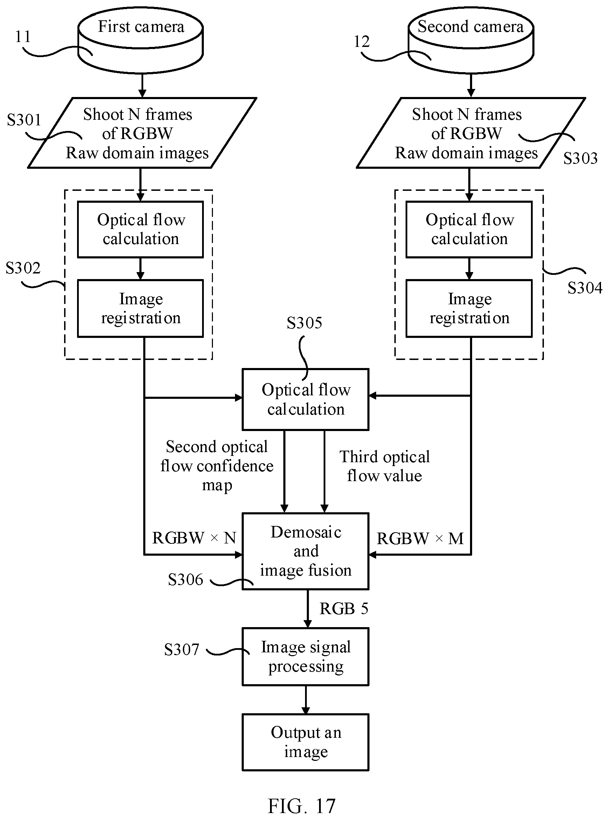

Alternatively, for example, in some embodiments of this application, when the user selects a dual-camera mode by using an interface, to simultaneously turn on the first camera 11 and the second camera 12, and when the user triggers the camera button 03 in the electronic device 01 shown in FIG. 8, the processor 02 may send, based on the user operation, control instructions to the first camera 11 and the second camera 12 shown in FIG. 17. The following image processing method may include S301 to S307 shown in FIG. 17.

S301: Shoot N frames of RGBW Raw domain images.

S301 is similar to S201, and details are not described herein again. Similarly, in some embodiments of this application, when N > 1, the processor 02 may perform the following S301 to register the N frames of RGBW Raw domain images. Alternatively, in some other embodiments of this application, when N = 1, the processor 02 may skip S302 and directly perform S306.

S302: Optical flow calculation and image registration.

Specifically, in a process of performing S302, the processor 02 may select, from N frames of first Raw domain images, one frame of image as a fifth reference image (for example, a first frame of image), and a remaining image as a fifth to-be-registered image. Next, calculate a sixth optical flow value between each frame of fifth to-be-registered image and the fifth reference image by using the optical flow algorithm. Then, deform the fifth to-be-registered image based on the sixth optical flow value and by using the fifth reference image as a baseline, and register the fifth to-be-registered image to the fifth reference image. In this way, registration of the N frames of RGBW first Raw domain images is completed.

S303: Shoot M frames of RGBW Raw domain images.

S303 is similar to S204, and details are not described herein again. Similarly, in some embodiments of this application, when M > 1, the processor 02 may perform the following S304 to register the N frames of RGBW Raw domain images. Alternatively, in some other embodiments of this application, when M = 1, the processor 02 may skip S304 and directly perform S305.

S304: Optical flow calculation and image registration.

Specifically, in a process of performing S304, the processor 02 may select, from N frames of second Raw domain images, one frame of image as a sixth reference image (for example, a first frame of image), and a remaining image as a sixth to-be-registered image. Next, calculate a seventh optical flow value between each frame of sixth to-be-registered image and the sixth reference image by using the optical flow algorithm. Then, deform the sixth to-be-registered image based on the seventh optical flow value and by using the sixth reference image as a baseline, and register the sixth to-be-registered image to the sixth reference image. In this way, registration of the M frames of RGBW second Raw domain images is completed.

S305: Optical flow calculation.

Specifically, in a process of performing S305, the processor 02 may calculate, by using the foregoing optical flow algorithm, the fifth optical flow value between the fifth reference image (for example, the first frame) in the N frames of RGBW first Raw domain images and the sixth reference image (for example, the first frame) in the M frames of RGBW second Raw domain images, and obtain a second optical flow confidence map. Therefore, an offset between the fifth reference image and the sixth reference image may be obtained by using the fifth optical flow value. In addition, an area that is not shot and that exists on an edge part of the object shot due to a parallax between the first camera 11 and the second camera 12 is obtained by using the second optical flow confidence map.

S306: Demosaic and image fusion.

Specifically, in a process of performing the foregoing S306, the processor 02 fusions registered and aligned N frames of first Raw domain images, registered and aligned M frames of second Raw domain images, and the second optical flow confidence map based on the fifth optical flow value, and performs demosaic processing to obtain an RGB domain image.

In this way, in a fusion process, the fifth reference image in the first Raw domain image shot by the primary camera may be used as a baseline, the sixth reference image in the second Raw domain image may be deformed, and the sixth reference image is registered to the fifth reference image. In this way, the N frames of first Raw domain images are registered with the M frames of second Raw domain images. In addition, the registered and aligned N frames of first Raw domain images, the registered and aligned M frames of second Raw domain images, and the second optical flow confidence map are fused, so that not only information loss and fusion ghosting caused by a parallax in a dual-camera shooting process can be resolved, but also the second optical flow confidence map obtained through optical flow calculation can be used to constrain and guide an information loss area, to focus on color and texture repair of the information loss area by using the fifth reference image in the first Raw domain image as a baseline. In addition, the finally obtained RGB domain image can have both the rich details of the N frames of first Raw domain images and precise colors of the M frames of second Raw domain images, and texture and a color of a real object can be effectively restored at an edge location.

S307: Image signal processing.

Specifically, the ISP module in the processor 02 may perform S307, to perform processing such as automatic white balance processing, color correction processing, and distortion correction processing on the RGB domain image. Then, the processed image may be transmitted to a display of an electronic device 01 for display, so that the user sees the image finally shot.

It can be learned from the foregoing description that a difference between the solution shown in FIG. 17 and the solution shown in FIG. 14 lies in that, in the solution shown in FIG. 17, steps of demosaic and image fusion are combined, so that the registered and aligned N frames of first Raw domain images, the registered and aligned M frames of second Raw domain images, and the second optical flow confidence map are jointly used as inputs of a module that has both a demosaic function and an image fusion function. In this way, the module may combine detail expressiveness of the registered and aligned N frames of first Raw domain images and precision of colors of the registered and aligned M frames of second Raw domain images, and perform targeted repair on an occluded area caused by a dual camera based on the second optical flow confidence map. Because the registered and aligned N frames of first Raw domain images and the registered and aligned M frames of second Raw domain images are simultaneously processed with demosaic, compared with the solution in which demosaic is separately performed, a demosaic algorithm can be reduced, thereby reducing an error caused by demosaic processing.

The foregoing descriptions are merely specific implementations of this application, but are not intended to limit the protection scope of this application. Therefore, the protection scope of this application shall be subject to the protection scope of the claims.

## Claims

1. An image sensor (20a), comprising:
a first light filter (200), comprising a plurality of first light filter units (210) arranged in an array, wherein the first light filter unit (210) comprises a plurality of light filter blocks (211) arranged in an array, the plurality of light filter blocks (211) comprise first transparent light filter blocks, W1, second transparent light filter blocks, W2, and at least two color light filter components, each color light filter component comprises at least three color light filter blocks (212) respectively configured to transmit three-primary-color light, the first transparent light filter blocks W1 and the color light filter blocks (212) are arranged in an alternate manner along a horizontal direction X and a vertical direction Y of the array formed by the plurality of light filter blocks (211), and the second transparent light filter blocks W2 are disposed in a periphery of an area in which the first transparent light filter blocks W1 and the color light filter blocks (212) are located; and
a plurality of photoelectric conversion elements (41), wherein each light filter block (211) covers one photoelectric conversion element (41), and the photoelectric conversion element (41) is configured to convert light passing through the light filter block (211) into an electrical signal;
wherein the at least two color light filter components comprise a first light filter component (40a) and a second light filter component (40b); and
in a same first light filter unit (210), a plurality of first transparent light filter blocks W1 and a plurality of color light filter blocks (212) are arranged in a 4 × 4 matrix; and any one of the first light filter component (40a) and the second light filter component (40b) comprises one red light filter block, one blue light filter block, and two green light filter blocks; and
wherein
a red light filter block and a blue light filter block in the first light filter component (40a) and a red light filter block and a blue light filter block in the second light filter component (40b) are sequentially arranged along a direction of a diagonal of the 4 × 4 matrix; and
two green light filter blocks in the first light filter component (40a) and two green light filter blocks in the second light filter component (40b) are respectively distributed on both sides of the diagonal of the 4 × 4 matrix.

2. The image sensor (20a) according to claim 1, wherein the plurality of light filter blocks (211) in the first light filter unit (210) are arranged in an S × J matrix, wherein 4 < S, 4 < J, and S and J are even numbers.

3. A camera (11), comprising a lens assembly (30) and the image sensor (20a) according to any one of claims 1 to 2, wherein the lens assembly (30) is disposed on a light incident side of the image sensor (20a).

4. An electronic device (01), comprising a processor (02) and a first camera (11) electrically connected to the processor (02), wherein the first camera (11) is the camera (11) according to claim 3.

5. The electronic device (01) according to claim 4, wherein the electronic device (01) further comprises a second camera electrically (12) connected to the processor (02);
the second camera (12) comprises a second light filter, the second light filter comprises a plurality of second light filter units (310) arranged in an array, and each second light filter unit comprises one red light filter block, one blue light filter block, and two green light filter blocks arranged in a 2 × 2 matrix; and
the two green light filter blocks are arranged along one diagonal of the 2 × 2 matrix, and the red light filter block and the blue light filter block are arranged along the other diagonal of the 2 × 2 matrix.

## Patentansprüche

1. Bildsensor (20a), umfassend:
einen ersten Lichtfilter (200), umfassend eine Vielzahl erster Lichtfiltereinheiten (210), die in einem Array angeordnet ist, wobei die erste Lichtfiltereinheit (210) eine Vielzahl von Lichtfilterblöcken (211) umfasst, die in einem Array angeordnet ist, die Vielzahl von Lichtfilterböcken (211) erste transparente Lichtfilterblöcke, W1, zweite transparente Lichtfilterblöcke, W2, und mindestens zwei Farblichtfilterkomponenten umfasst, jede Farblichtfilterkomponente mindestens drei Farblichtfilterblöcke (212) umfasst, die jeweils dazu konfiguriert sind, Licht der drei Primärfarben zu übertragen, die ersten transparenten Lichtfilterblöcke W1 und die Farblichtfilterblöcke (212) in einer abwechselnden Weise entlang einer horizontalen Richtung X und einer vertikalen Richtung Y des Arrays angeordnet sind, das durch die Vielzahl von Lichtfilterblöcken (211) gebildet wird, und die zweiten transparenten Lichtfilterblöcke W2 in einer Peripherie eines Bereichs vorgesehen sind, in dem sich die ersten transparenten Lichtfilterblöcke W1 und die Farblichtfilterblöcke (212) befinden; und
eine Vielzahl fotoelektrischer Umwandlungselemente (41), wobei jeder Lichtfilterblock (211) ein fotoelektrisches Umwandlungselement (41) abdeckt und das fotoelektrische Umwandlungselement (41) dazu konfiguriert ist, Licht, das durch den Lichtfilterblock (211) hindurchgeht, in ein elektrisches Signal umzuwandeln;
wobei die mindestens zwei Farblichtfilterkomponenten eine erste Lichtfilterkomponente (40a) und eine zweite Lichtfilterkomponente (40b) umfassen; und
in einer gleichen ersten Lichtfiltereinheit (210) eine Vielzahl erster transparenter Lichtfilterblöcke W1 und eine Vielzahl von Farblichtfilterblöcken (212) in einer 4×4-Matrix angeordnet sind; und jede der ersten Lichtfilterkomponente (40a) und der zweiten Lichtfilterkomponente (40b) einen Rotlichtfilterblock, einen Blaulichtfilterblock und zwei Grünlichtfilterblöcke umfasst; und
wobei
ein Rotlichtfilterblock und ein Blaulichtfilterblock in der ersten Lichtfilterkomponente (40a) und ein Rotlichtfilterblock und ein Blaulichtfilterblock in der zweiten Lichtfilterkomponente (40b) aufeinanderfolgend entlang einer Richtung einer Diagonalen der 4×4-Matrix angeordnet sind; und
zwei Grünlichtfilterblöcke in der ersten Lichtfilterkomponente (40a) und zwei Grünlichtfilterblöcke in der zweiten Lichtfilterkomponente (40b) jeweils auf einer der beiden Seiten der Diagonalen der 4×4-Matrix verteilt sind.

2. Bildsensor (20a) nach Anspruch 1, wobei die Vielzahl von Lichtfilterblöcken (211) in der ersten Lichtfiltereinheit (210) in einer S×J-Matrix angeordnet ist, wobei 4 < S, 4 < J und S und J gerade Zahlen sind.

3. Kamera (11), umfassend eine Linsenbaugruppe (30) und den Bildsensor (20a) nach einem der Ansprüche 1 oder 2, wobei die Linsenbaugruppe (30) auf einer lichteinfallenden Seite des Bildsensors (20a) vorgesehen ist.

4. Elektronische Vorrichtung (01), umfassend einen Prozessor (02) und eine erste Kamera (11), die elektrisch mit dem Prozessor (02) verbunden ist, wobei die erste Kamera (11) die Kamera (11) nach Anspruch 3 ist.

5. Elektronische Vorrichtung (01) nach Anspruch 4, wobei die elektronische Vorrichtung (01) ferner eine zweite Kamera (12) umfasst, die elektrisch mit dem Prozessor (02) verbunden ist;
die zweite Kamera (12) einen zweiten Lichtfilter umfasst, der zweite Lichtfilter eine Vielzahl zweiter Lichtfiltereinheiten (310) umfasst, die in einem Array angeordnet ist, und jede zweite Lichtfiltereinheit einen Rotlichtfilterblock, einen Blaulichtfilterblock und zwei Grünlichtfilterblöcke umfasst, die in einer 2×2-Matrix angeordnet sind; und
die zwei Grünlichtfilterblöcke entlang einer Diagonalen der 2×2-Matrix angeordnet sind und der Rotlichtfilterblock und der Blaulichtfilterblock entlang der anderen Diagonalen der 2×2-Matrix angeordnet sind.

## Revendications

1. Capteur d'images (20a), comprenant :
un premier filtre de lumière (200), comprenant une pluralité de premières unités de filtre de lumière (210) disposées en réseau, dans lequel la première unité de filtre de lumière (210) comprend une pluralité de blocs de filtre de lumière (211) disposés en réseau, la pluralité de blocs de filtre de lumière (211) comprend des premiers blocs de filtre de lumière transparents, W1, des seconds blocs de filtre de lumière transparents, W2, et au moins deux composants de filtre de lumière colorés, chaque composant de filtre de lumière coloré comprend au moins trois blocs de filtre de lumière colorés (212) configurés respectivement pour transmettre une lumière à trois couleurs primaires, les premiers blocs de filtre de lumière transparents W1 et les blocs de filtre de lumière colorés (212) sont disposés de manière alternée le long d'une direction horizontale X et d'une direction verticale Y du réseau formé par la pluralité de blocs de filtre de lumière (211), et les seconds blocs de filtre de lumière transparents W2 sont disposés à la périphérie d'une zone dans laquelle se trouvent les premiers blocs de filtre de lumière transparents W1 et les blocs de filtre de lumière colorés (212) ; et
une pluralité d'éléments de conversion photoélectrique (41), dans lequel chaque bloc de filtre de lumière (211) recouvre un élément de conversion photoélectrique (41), et l'élément de conversion photoélectrique (41) est configuré pour convertir la lumière passant à travers le bloc de filtre de lumière (211) en un signal électrique ;
dans lequel les au moins deux composants de filtre de lumière colorés comprennent un premier composant de filtre de lumière (40a) et un second composant de filtre de lumière (40b) ; et
dans une même première unité de filtre de lumière (210), une pluralité de premiers blocs de filtre de lumière transparents W1 et une pluralité de blocs de filtre de lumière colorés (212) sont disposés dans une matrice 4 × 4 ; et l'un quelconque du premier composant de filtre de lumière (40a) et du second composant de filtre de lumière (40b) comprend un bloc de filtre de lumière rouge, un bloc de filtre de lumière bleue et deux blocs de filtre de lumière verte ; et
dans lequel
un bloc de filtre de lumière rouge et un bloc de filtre de lumière bleue dans le premier composant de filtre de lumière (40a) et un bloc de filtre de lumière rouge et un bloc de filtre de lumière bleue dans le second composant de filtre de lumière (40b) sont disposés séquentiellement le long d'une direction d'une diagonale de la matrice 4 × 4 ; et
deux blocs de filtre de lumière verte dans le premier composant de filtre de lumière (40a) et deux blocs de filtre de lumière verte dans le second composant de filtre de lumière (40b) sont respectivement répartis des deux côtés de la diagonale de la matrice 4 × 4.

2. Capteur d'images (20a) selon la revendication 1, dans lequel la pluralité de blocs de filtres de lumière (211) dans la première unité de filtre de lumière (210) sont disposés dans une matrice S × J, dans lequel 4 < S, 4 < J, et S et J sont des nombres pairs.

3. Caméra (11), comprenant un ensemble de lentilles (30) et le capteur d'images (20a) selon l'une quelconque des revendications 1 et 2, dans laquelle l'ensemble de lentilles (30) est disposé sur un côté d'incidence de lumière du capteur d'images (20a).

4. Dispositif électronique (01), comprenant un processeur (02) et une première caméra (11) connectée électriquement au processeur (02), dans lequel la première caméra (11) est la caméra (11) selon la revendication 3.

5. Dispositif électronique (01) selon la revendication 4, dans lequel le dispositif électronique (01) comprend en outre une seconde caméra (12) connectée électriquement au processeur (02) ;
la seconde caméra (12) comprend un second filtre de lumière, le second filtre de lumière comprend une pluralité de secondes unités de filtre de lumière (310) disposées en réseau, et chaque seconde unité de filtre de lumière comprend un bloc de filtre de lumière rouge, un bloc de filtre de lumière bleue et deux blocs de filtre de lumière verte disposés dans une matrice 2 × 2 ; et
les deux blocs de filtres de lumière verte sont disposés le long d'une diagonale de la matrice 2 × 2, et le bloc de filtre de lumière rouge et le bloc de filtre de lumière bleue sont disposés le long de l'autre diagonale de la matrice 2 × 2.
